# FASCICULE DE BREVET EUROPEEN

(11) **EP 2 741 592 B1**
(45) Date de publication et mention de la délivrance du brevet: **02.09.2015**
(21) Numéro de dépôt: 13306535.9
(22) Date de dépôt: 08.11.2013
(51) Int. Cl.: H05K 3/36, H05K 1/02, H05K 3/34, H05K 1/14

(54) **Dispositif électronique comprenant une protection thermique par composant électronique intercalaire, module comprenant ce dispositif et procédé de fabrication du dispositif.**
Elektronische Vorrichtung umfassend einen Wärmeschutz mittels einer elektronischen Zwischenkomponente, Modul umfassend solch eine Vorrichtung und Verfahren zur Herstellung dieser Vorrichtung
Electronic device comprising a heat protection by means of an inserted electronic component, module comprising such a device and process for manufacturing such a device.

(30) Priorité: 04.12.2012 FR 1261617
(43) Date de publication de la demande: 11.06.2014
(73) Titulaire: HAGER CONTROLS (Société par Actions Simplifiée), 67700 Saverne (FR)
(72) Inventeur: Lugbull, Pierre Alain, 67700 Otterswiller (FR); Colinmaire, Thierry, 57370 Saint Jean Kourtzerode (FR)
(74) Mandataire: Nuss, Laurent

(56) Documents cités:
- EP-A1- 1 708 357
- US-A1- 2003 186 569
- US-A1- 2010 001 398

## Description

La présente invention relève du domaine des équipements électroniques à carte de circuit imprimé, destinés notamment à une utilisation dans des installations électriques domestiques, et a pour objet, d'une part, un dispositif électronique particulier, ainsi que, d'une part, un module de contrôle domotique le comprenant, et, d'autre part, son procédé de fabrication.

La fixation par soudure des composants électroniques d'un dispositif électronique sur une carte de circuit imprimé s'accompagne naturellement d'une élévation locale et temporaire de la température, qui peut se révéler néfaste pour certains d'entre eux, en particulier pour des procédés par vague d'étain.

Certains composants électroniques présentent alors, à leur face destinée à venir contre la carte de circuit imprimée, une isolation adaptée, limitant l'effet de cette élévation de température, grâce à une couche protectrice plastique ou une conception adaptée, plaçant par exemple les parties sensibles à distance de la source de chaleur. Toutefois, cet aménagement peut se révéler inutile dès lors que le composant n'est pas placé, par rapport au côté de la carte de circuit imprimé où les soudures sont pratiquées, comme prévu, c'est-à-dire si sa face isolée n'est pas celle qui est la plus proche de la carte. Dans ce cas, c'est une face moins bien protégée qui se trouve contre la carte de circuit imprimée, ce qui peut donc amener à nouveau à dégrader le composant.

Cela peut en particulier être le cas si, pour des raisons de volume disponible et de dimensions du composant électronique, celui-ci est finalement placé sur une carte fille, elle-même ensuite placée perpendiculairement à la carte mère, sur laquelle les composants sont ensuite soudés. En outre, pour des gains de place, le composant est alors bien souvent placé très proche de la carte mère, et ne profite donc pas de l'isolation qui serait obtenue naturellement par l'air qui pourrait les séparer s'ils étaient décalés. Pour un tel composant électronique, c'est donc une des faces latérales, et donc non optimisée thermiquement, qui se trouve dans l'environnement immédiat de la source de chaleur, ce qui peut dégrader le composant.

On connaît alors des solutions consistant essentiellement à placer, entre la face latérale sensible du composant et la carte mère, parallèles, un film isolant, ou encore des cales adaptées, pour décaler volontairement le composant de la carte mère et/ou pour les séparer par une matière isolante.

Les inconvénients essentiels de ce type de solution est qu'il rajoute une étape au procédé de fabrication, et/ou des composants supplémentaires, autres que ceux déjà prévus sur la carte.

Des dispositifs électroniques comprenant des composants électroniques superposés sont connus des documents EP 1 708 357 A1, US 2003/186569 A1 et US 2010/001398 A1.

La présente invention a pour but de pallier ces inconvénients et propose ainsi d'utiliser directement des composants électroniques pour garantir l'écartement entre, d'une part, la carte mère, qui subit les opérations de soudage, et, d'autre part, le composant électronique thermiquement sensible.

A cet effet, l'invention a tout d'abord pour objet un dispositif électroniques selon la revendication 1.

L'invention a aussi pour objet un module de contrôle domotique présentant une partie puissance comprenant des lignes électriques dont l'état dépend d'au moins un relais, ainsi qu'une partie de contrôle, permettant le pilotage desdits relais, et comprenant un tel dispositif électronique.

L'invention a enfin pour objet un procédé de fabrication d'un tel dispositif électronique, comprenant les étapes définies dans la revendication 9.

L'invention sera mieux comprise, grâce à la description ci-après, qui se rapporte à un mode de réalisation préféré, donné à titre d'exemple non limitatif, et expliqué avec référence aux dessins schématiques annexés, dans lesquels :
- la figure 1 illustre un dispositif électronique, avec une vue montrant en particulier la face arrière de la carte fille ;
- la figure 2 illustre un tel dispositif électronique avec une vue montrant en particulier le côté arrière de la carte mère, où les pattes traversantes de certains composants électroniques sont soudés par passage à la vague, et
- la figure 3 illustre un tel dispositif avec une vue montrant en particulier le décalage avec la carte mètre.

L'invention a donc tout d'abord pour objet un dispositif électronique 1 comprenant des composants électroniques 2 et une première carte de circuit imprimée, dite carte mère 5, présentant elle-même, d'une part, un premier côté, dit côté composants 4, où se trouve une partie des composants électroniques 2, et, d'autre part, à l'opposé, un côté arrière 3, où se trouvent des soudures pour des pattes de connexion de composant électronique 2.

La carte mère 5 peut combiner des pistes électriques pour la circulation d'un courant de puissance, pouvant être de l'ordre de la dizaine d'ampères, avec des pistes électriques pour la circulation d'un courant porteur d'une information, pouvant être inférieur à l'ampère. Les composants électroniques 2 peuvent donc être de différents types : transistors, résistances, condensateur, diode, etc., et éventuellement être reliés aux pistes de puissance et/ou aux pistes pour la communication.

La soudure d'un composant 2 qui est monté sur la carte mère 5 se trouve donc du côté arrière 3, le corps du composant 2 se trouvant du côté composant 4, ce qui est une disposition classique pour la fixation de composants électroniques 2 sur une carte de circuit imprimé. Les pattes des composants électroniques 2, traversant la carte de circuit imprimé, en l'occurrence la carte mère 5, sont donc soudées du côté arrière 3, notamment par passage à la vague. Certains composants électroniques 2 peuvent bien entendu, compte tenu de leur conception, être directement soudés sur le côté composants 4, par exemple pour un composant CMS. Un tel composant peut alors être soudé du côté composants 4 par un procédé de refusion, par exemple.

Certains des composants 2 électroniques du dispositif électronique 1 selon l'invention peuvent bien entendu se trouver ailleurs que sur la carte mère 5, en particulier sur une carte fille 8, encore décrite plus loin, ou encore sur une autre carte.

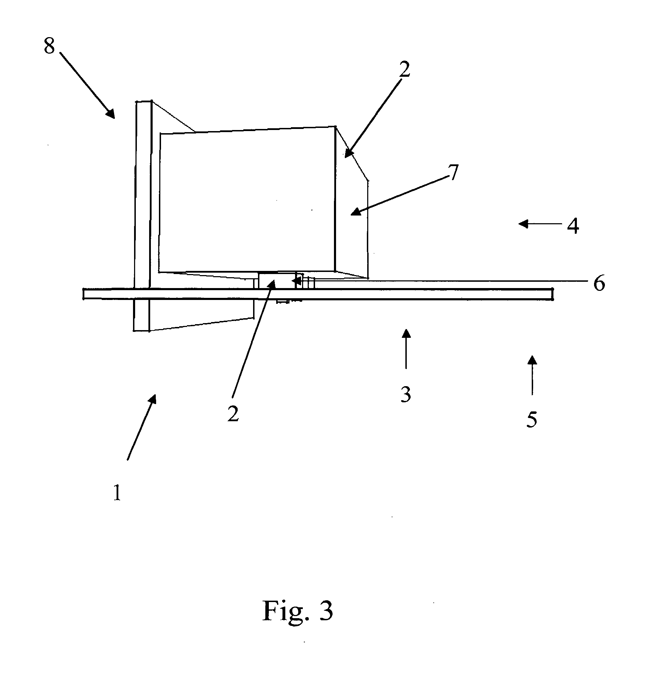

Selon l'invention, des composants électroniques 2 sont superposés du côté composants 4 de la carte mère 5, de sorte qu'au moins un composant électronique 2, dit composant intercalaire 6, se trouve directement entre, d'une part, la carte mère 5, et, d'autre part, un autre composant électronique 2, dit composant superposé 7. La figure 3 en particulier montre que le composant intercalaire 6 permet d'assurer le décalage entre, d'une part, la carte mère 5, dont le côté arrière 3 sera soumis, lors de la fabrication, à une forte élévation de température, et, d'autre part, un composant électronique 2 sensible à la température. Bien entendu, un plusieurs composants intercalaires 6 peuvent se trouver sous un même composant superposé 7, et la carte mère 5 peut présenter plusieurs configurations de la sorte, présentant chacune un composant superposé, maintenu à distance de la carte mère 5 par au moins un composant intercalaire 6.

Le composant superposé 7 peut, comme le composant intercalaire 6, être fixé par soudage à la carte mère 5, bien qu'il s'agisse là a priori d'une configuration dans laquelle le composant superposé 7 est le mieux placé par rapport au côté arrière 3 de la carte mère 5, puisque sa surface la plus proche de la carte mère 5 est celle prévue à cet effet.

Le composant intercalaire 6 assure donc que le composant superposé 7 ne soit pas directement en contact avec la carte mère 5, dont la température augmentera à l'occasion de l'opération de soudage. Il assure aussi en permanence une circulation d'air entre le composant superposé 7 et la carte mère 5, qui peut chauffer compte tenu de la circulation d'un courant de puissance. Le composant intercalaire 6 fait donc office à la fois de cale, en contact avec le composant superposé 7, et de composant fonctionnel dans le dispositif électronique 1. Lors du montage, le composant intercalaire 6 peut aussi servir de butée pour le positionnement du composant superposé 7, au quel cas ils viennent alors au contact l'un de l'autre. Bien entendu, le contact entre eux n'est pas indispensable, et un léger intervalle entre eux permettrait, en outre, d'éviter une transmission de chaleur par conduction.

Dans l'absolu, rien ne limite la localisation de la soudure du composant intercalaire 6 et du composant superposé 7, de sorte qu'ils peuvent être soudés sur la même carte de circuit imprimé ou non, à savoir la carte mère, par exemple, ou la carte fille 8, décrite ci-dessous. Toutefois, de façon avantageuse, et selon une caractéristique additionnelle possible, le au moins un composant électronique intercalaire 6 est soudé sur la carte mère 5. Il est ainsi possible de positionner aisément le composant intercalaire 6 en fonction de l'endroit du composant superposé 7. Par conséquent, la position de certains de composants électroniques 2 du dispositif électronique 1, à savoir celle des composants montés sur la carte mère 5, tient compte de l'utilisation du composant intercalaire 6 pour décaler le composant superposé 7 de la carte mère 5. Les pistes électriques auxquelles les composants intercalaires 6 sont soudées sont donc aussi adaptées pour permettre un contact électrique avec un composant intercalaire, placé au niveau du composant superposé 7. La carte mère 5 est donc conçue aussi en fonction de la position des composants superposés 7, qui seront toutefois éventuellement fixés sur une carte fille 5.

Selon une caractéristique additionnelle possible, le au moins un composant électronique intercalaire 6 a un encapsulage en matière plastique ou autre matière thermiquement isolante. Afin de limiter le transfert de chaleur par conduction jusqu'au composant superposé 7, il est donc avantageux que le composant intercalaire 6 conduise peu la chaleur, surtout lorsqu'il est en contact, outre le contact normal des broches de soudage, avec la carte mère 5, qui transmettra elle-même la chaleur générée lors de l'opération de soudage du côté arrière 3. Pour ce faire, le recours à un composant intercalaire 6 qui présente un enrobage de plastique est particulièrement avantageux, cette matière étant en effet moins conductrice thermique que d'autres utilisées pour les composants électroniques : métal, céramique ou autres.

Ainsi, il peut être particulièrement avantageux d'utiliser des transistors pour le composant intercalaire 6, ces derniers présentant souvent une couche externe en matière plastique, ce qui permet donc d'envisager un contact entre le composant intercalaire 6 et le composant superposé 7, sans passage excessif de chaleur de l'un à l'autre.

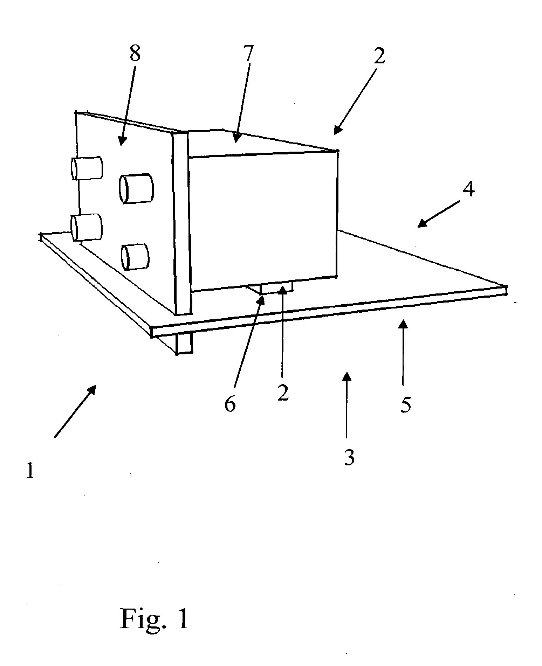

Selon une caractéristique additionnelle possible du dispositif électronique 1, il présente une deuxième carte de circuit imprimé, placée perpendiculairement à la carte mère 5 et sur laquelle est soudée le au moins un composant électronique superposé 7. Ce montage est visible en particulier à la figure 1, qui montre les deux cartes de circuit imprimé montées perpendiculairement l'une par rapport à l'autre, le composant superposé 7 étant monté sur la carte perpendiculaire à la carte mère 5. Ce montage peut en effet être imposé, compte tenu, d'une part, du volume disponible pour le dispositif électronique 1, et, d'autre part, de l'encombrement et de la forme géométrique du composant superposé 7. Afin de garantir que l'appareil dans lequel le dispositif électronique 1 est monté respecte un certain gabarit géométrique, il peut être nécessaire d'envisager de positionner le composant superposé 7 perpendiculairement à la carte mère 5, sur laquelle il devrait normalement être directement fixé. C'est alors que le problème de l'échauffement excessif du composant superposé 7 est le plus marqué et qu'il est donc particulièrement intéressant d'envisager des composants intercalaires 6 pour décaler de la carte mère 5 une de ses surfaces qui n'est pas destinée à être la plus proche d'une source de chaleur, à savoir une surface latérale.

Selon une caractéristique additionnelle possible, la deuxième carte de circuit imprimé est fixée à la carte mère 5 par soudure de sorte à former une carte fille 8, reliée mécaniquement et électriquement à ladite carte mère 5. La carte mère 5 et la carte fille 8 sont donc reliées l'une à l'autre au niveau de leur arête commune, la connexion électrique entre les pistes électriques, d'une part, de la carte mère 5, et, d'autre part, de la carte fille 8, se faisant aussi au niveau de la jointure entre ces deux cartes.

Dans des modes de réalisation particuliers, le au moins un composant électronique superposé 7 prend la forme d'un relais, ce qui implique donc la circulation d'un courant de puissance ainsi que d'un courant de contrôle, et ce tant dans la carte mère 5 que dans la carte 8, grâce à la connexion électrique et mécanique entre ces deux cartes.

Un relais pouvant être particulièrement sensible à la température, l'invention est particulièrement avantageuse pour un tel composant.

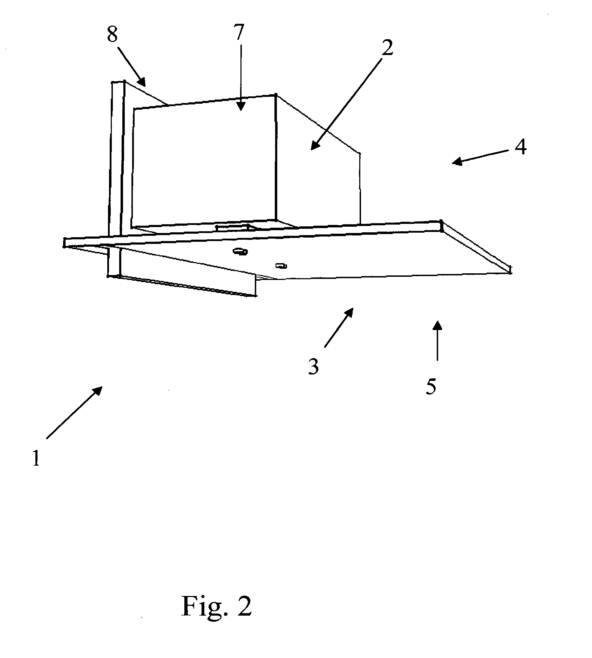

Ainsi, dans la réalisation du dispositif électronique 1 telle qu'illustrée dans les figures 1 à 3, il présente une carte mère 5, portant des composants électroniques intercalaires 6 soudés sur elle et placés du côté composants 4,
il présente, en outre, une carte fille 8, perpendiculaire à la carte mère 5 et soudée à elle pour les relier mécaniquement et électriquement,
la dite carte fille 8 présentant un composant électronique superposé 7, soudé à elle et positionné contre les composants électroniques intercalaires 6, décalé de la carte mère 5.

L'invention a aussi pour objet un module domotique comprenant un tel dispositif électronique 1. Dans l'absolu, un tel dispositif électronique 1 peut bien entendu être utilisé dans tout type d'équipement électronique. Ainsi, l'invention porte aussi plus particulièrement sur un module de contrôle domotique présentant une partie puissance comprenant des lignes électriques dont l'état dépend d'au moins un relais, ainsi qu'une partie de contrôle, permettant le pilotage desdits relais.

Un tel module domotique peut donc être piloté par des instructions circulant sur un réseau filaire auquel il est connecté, ces instructions étant ensuite prises en compte par une unité de traitement pour piloter des relais qui se trouvent montés dans des lignes de puissance. Il est donc possible d'actionner, par un ordre envoyé depuis un appareil de contrôle tel qu'un interrupteur sur un réseau de communication, un consommateur électrique situé à distance. Un tel module domotique présente donc généralement un alignement géométrique de bornes d'entrée, tant pour la partie contrôle que pour la partie puissance, ainsi qu'un alignement géométrique de bornes de sorties, là aussi tant pour la partie contrôle que pour la partie puissance. Les relais ne forment qu'un exemple particulier d'influence exercée sur une piste électrique. Il peut aussi s'agir, par exemple d'un gradateur ou autre.

Selon l'invention, ce module domotique comprend au moins un dispositif électronique 1 tel que décrit ci-dessus, notamment dont les composants superposés 7 sont les relais de contrôle des lignes de puissance. La carte mère 5 du dispositif électronique 1 peut donc être la carte de circuit imprimé principale du module domotique, dans laquelle sont aménagées des pistes pour la circulation des informations et autres courants de contrôle pour des composants électroniques 2, ainsi que des pistes pour la circulation d'un courant de puissance.

Enfin, l'invention a aussi pour objet un procédé de fabrication d'un dispositif électronique 1 tel que décrit plus haut, et comprenant les étapes consistant à positionner et fixer par soudage sur au moins une carte de circuit imprimé, dite carte mère 5, au moins un composant électronique 2, ce qui forme une étape normale de fixation de composants électronique sur une carte mère. Ces composants peuvent concerner ensuite la partie puissance et/ou la partie de contrôle.

Selon l'invention, des composants électroniques 2 sont positionnés superposés du côté composants 4 de la carte mère 5, de sorte qu'au moins un composant électronique 2, dit composant intercalaire 6, se trouve directement entre, d'une part, la carte mère 5, et, d'autre part, un autre composant électronique 2, dit composant superposé 7, le au moins un composant intercalaire 6 arrivant notamment au voisinage immédiat, voire au contact, d'une part, du composant superposé 7, et, d'autre part, de la carte mère 5.

Comme il a déjà été évoqué, le composant intercalaire 6 peut servir de butée lors du positionnement du composant superposé 7 : en effet, il peut être en contact contre la carte mère 5, et/ou contre le composant superposé 7. Dans des modes de réalisation particuliers, le procédé comprend des étapes consistant essentiellement à
fixer par soudage, sur une carte fille 8, au moins un composant électronique superposé 7,
positionner au moins un composant électronique intercalaire 6 sur la carte mère 5, du côté composants 4,
placer la carte fille 8 perpendiculairement à la carte mère 5 et de sorte que le au moins un composant électronique superposé 7 se trouve au contact ou au voisinage immédiat du au moins un composant électronique intercalaire 6,
souder le au moins un composant intercalaire 6 à la carte mère 5, et souder la carte fille 8 à la carte mère 5, notamment simultanément grâce à une soudure par vague d'étain du côté arrière 3.

Le composant électronique intercalaire 6 peut être directement soudé à la carte mère 5 du côté composants 4, avant la soudure entre les deux cartes, mais peut aussi présenter des pattes qui traversent la carte mère 5 et sont soudées du côté arrière 3. Dans ce deuxième cas, les soudages, sur la carte mère 5, de la carte fille 8, d'une part, et du composant intercalaire 6, d'autre part, peuvent être effectués en une seule et même opération.

Il est ainsi possible de réaliser la fixation du composant superposé 7 à la carte fille 8 avant la fixation de la carte fille 8 à la carte mère 5. La fixation du composant intercalaire 6 sur la carte mère 5 peut être réalisée avant la fixation l'une à l'autre des deux cartes, pendant cette opération de fixation mutuelle, ou encore après.

Préférentiellement, le composant superposé 7 est fixé à la carte fille 8, puis cette dernière vient être positionnée par rapport à la carte mère 5 de sorte que le composant superposé 7 vient en butée contre le composant intercalaire 6. Le composant intercalaire 6 contribue donc aussi à stabiliser dans sa position la carte fille 8, sur laquelle est monté le composant superposé 7, et ce lors de l'opération consistant à fixer l'une à l'autre la carte mère 5 et la carte fille 8.

Bien entendu, l'invention n'est pas limitée aux modes de réalisation décrits et représentés aux dessins annexés. Des modifications restent possibles, notamment du point de vue de la constitution des divers éléments, par combinaison différente de tout ou partie des caractéristiques décrites ci-dessus, sans sortir pour autant du domaine de protection de l'invention, telle que définie dans les revendications indépendantes 1, 8 et 9.

## Revendications

1. Dispositif électronique (1) comprenant des composants électroniques (2) et une première carte de circuit imprimée, dite carte mère (5), présentant elle-même un premier côté, dit côté composants (4), où se trouve une partie des composants électroniques (2), des composants électroniques (2) étant superposés du côté composants (4) de la carte mère (5), de sorte qu'au moins un composant électronique (2), dit composant intercalaire (6), se trouve directement entre, d'une part, la carte mère (5), et, d'autre part, un autre composant électronique (2), dit composant superposé (7),
**caractérisé en ce que**
la carte mère (5), à l'opposé du premier côté, présente un côté arrière (3), où se trouvent des soudures pour des pattes de connexion de composant électronique (2).

2. Dispositif électronique (1) selon la revendication 1, **caractérisé en ce que**
le au moins un composant électronique intercalaire (6) est soudé sur la carte mère (5).

3. Dispositif électronique (1) selon l'une quelconque des revendications 1 à 2, **caractérisé en ce que**
le au moins un composant électronique intercalaire (6) a un encapsulage en matière plastique ou autre matière thermiquement isolante.

4. Dispositif électronique (1) selon l'une quelconque des revendications 1 à 3, **caractérisé en ce que**
il présente une deuxième carte de circuit imprimé, placée perpendiculairement à la carte mère (5) et sur laquelle est soudée le au moins un composant électronique superposé (7).

5. Dispositif électronique (1) selon la revendication 4, **caractérisé en ce que**
la deuxième carte de circuit imprimé est fixée à la carte mère (5) par soudure de sorte à former une carte fille (8), reliée mécaniquement et électriquement à ladite carte mère (5).

6. Dispositif électronique (1) selon l'une quelconque des revendications 1 à 5, **caractérisé en ce que**
le au moins un composant électronique superposé (7) prend la forme d'un relais.

7. Dispositif électronique (1) selon l'une quelconque des revendications précédentes, **caractérisé en ce que**
il présente une carte mère (5), portant des composants électroniques intercalaires (6) soudés sur elle et placés du côté composants (4),
il présente, en outre, une carte fille (8), perpendiculaire à la carte mère (5) et soudée à elle pour les relier mécaniquement et électriquement,
la dite carte fille (8) présentant un composant électronique superposé (7), soudé à elle et positionné contre les composants électroniques intercalaires (6), décalé de la carte mère (5).

8. Module de contrôle domotique présentant une partie puissance comprenant des lignes électriques dont l'état dépend d'au moins un relais, ainsi qu'une partie de contrôle, permettant le pilotage desdits relais, **caractérisé en ce que**
il comprend un dispositif électronique (1) selon l'une quelconque des revendications 1 à 7, notamment dont les composants superposés (7) sont les relais de contrôle des lignes de puissance.

9. Procédé de fabrication d'un dispositif électronique (1) selon l'une quelconque des revendications 1 à 7, comprenant les étapes consistant à positionner et fixer par soudage sur au moins une carte de circuit imprimé, dite carte mère (5), au moins un composant électronique (2),
et selon lequel
des composants électroniques (2) sont positionnés superposés du côté composants (4) de la carte mère (5), de sorte qu'au moins un composant électronique (2), dit composant intercalaire (6), se trouve directement entre, d'une part, la carte mère (5), et, d'autre part, un autre composant électronique (2), dit composant superposé (7), le au moins un composant intercalaire (6) arrivant notamment au voisinage immédiat, voire au contact, d'une part, du composant superposé (7), et, d'autre part, de la carte mère (5),
**caractérisé en ce que** la carte mère (5), à l'opposé du premier côté, présente un côté arrière (3), où se trouvent des soudures pour des pattes deconnexion de composant électronique (2).

10. Procédé de fabrication selon la revendication 9 **caractérisé en ce qu'il** comprend des étapes consistant essentiellement à
fixer par soudage, sur une carte fille (8), au moins un composant électronique superposé (7),
positionner au moins un composant électronique intercalaire (6) sur la carte mère (5), du côté composants (4),
placer la carte fille (8) perpendiculairement à la carte mère (5) et de sorte que le au moins un composant électronique superposé (7) se trouve au contact ou au voisinage immédiat du au moins un composant électronique intercalaire (6),
souder le au moins un composant intercalaire (6) à la carte mère (5), et souder la carte fille (8) à la carte mère (5).

## Patentansprüche

1. Elektronische Vorrichtung (1), umfassend elektronische Komponenten (2) und eine erste Leiterplatte, sogenannte Hauptplatine (5), welche selbst eine erste Seite aufweist, sogenannte Komponentenseite (4), auf der sich ein Teil der elektronischen Komponenten (2) befindet, wobei einige der elektronischen Komponenten (2) auf der Komponentenseite (4) der Hauptplatine (5) überlagert sind, so dass sich wenigstens eine elektrische Komponente (2), sogenannte Zwischenkomponente (6), direkt zwischen einerseits der Hauptplatine (5) und andererseits einer anderen elektronischen Komponente (2), sogenannte überlagerte Komponente (7), befindet, **dadurch gekennzeichnet, dass** die Hauptplatine (5) entgegengesetzt zu der ersten Seite eine Rückseite (3) aufweist, an der sich Lötstellen für Anschlussstifte der elektrischen Komponenten (2) befinden.

2. Elektronische Vorrichtung (1) nach Anspruch 1, **dadurch gekennzeichnet, dass** die wenigstens eine elektronische Zwischenkomponente (6) auf der Hauptplatine (5) angelötet ist.

3. Elektronische Vorrichtung (1) nach einem der Ansprüche 1 bis 2, **dadurch gekennzeichnet, dass** die wenigstens eine elektronische Zwischenkomponente (6) eine Einkapselung aus Kunststoff oder einem anderen thermisch isolierenden Material aufweist.

4. Elektronische Vorrichtung (1) nach einem der Ansprüche 1 bis 3, **dadurch gekennzeichnet, dass** sie eine zweite Leiterplatte aufweist, die senkrecht zu der Hauptplatine (5) angeordnet ist und an der die wenigstens eine elektronische überlagerte Komponente (7) angelötet ist.

5. Elektronische Vorrichtung (1) nach Anspruch 4, **dadurch gekennzeichnet, dass** die zweite Leiterplatte an der Hauptplatine (5) angelötet ist, um eine Tochterkarte (5) auszubilden, die mechanisch und elektrisch mit der Hauptplatine (5) verbunden ist.

6. Elektronische Vorrichtung (1) nach einem der Ansprüche 1 bis 5, **dadurch gekennzeichnet, dass** die wenigstens eine überlagerte elektronische Komponente (7) die Form eines Relais aufweist.

7. Elektronische Vorrichtung (1) nach einem der vorhergehenden Ansprüche, **dadurch gekennzeichnet, dass** sie eine Hauptplatine (5) aufweist, die Zwischenkomponenten (6) trägt, welche an ihr angelötet und auf der Komponentenseite (4) angeordnet sind, dass sie darüber hinaus senkrecht zur Hauptplatine (5) eine Tochterkarte (8) aufweist, die an ihr angelötet ist, um sie mechanisch und elektrisch zu verbinden, wobei die Tochterkarte (8) eine elektronische überlagerte Komponente (7) aufweist, die an ihr angelötet und versetzt von der Hauptplatine (5) an den elektronischen Zwischenkomponenten (6) angeordnet sind.

8. Häusliches Steuermodul, umfassend ein Leistungsteil mit elektrischen Leitungen, deren Zustand von wenigstens einem Relais abhängig ist, ebenso wie ein Steuerteil, welches die Steuerung des Relais ermöglicht, **dadurch gekennzeichnet, dass** es eine elektronische Vorrichtung (1) nach einem der Ansprüche 1 bis 7 umfasst, insbesondere bei der die überlagerten Komponenten (7) Steuerrelais der Leistungsleitungen sind.

9. Verfahren zur Herstellung einer elektronischen Vorrichtung (1) nach einem der Ansprüche 1 bis 7, umfassend die Schritte, die darin bestehen, wenigstens eine elektronische Komponente (2) auf wenigstens einer Leiterplatte, sogenannte Hauptplatine (5), zu positionieren und mittels Löten zu fixieren, wobei die elektronischen Komponenten (2) von der Komponentenseite (4) der Hauptplatine (5) überlagert positioniert sind, so dass wenigstens eine elektronische Komponente (2), sogenannte Zwischenkomponente (6), sich direkt zwischen einerseits der Hauptplatine (5) und andererseits einer elektronischen Komponente (2), sogenannte Zwischenkomponente (7) befindet, wobei die wenigstens eine Zwischenkomponente (6) insbesondere in unmittelbare Nachbarschaft und sogar in Kontakt einerseits mit der überlagerten Komponente (7) und andererseits mit der Hauptplatine (5) gelangt, **dadurch gekennzeichnet, dass** die Hauptplatine (5) entgegengesetzt zur ersten Seite eine Rückseite (3) aufweist, an der sich Lötstellen für die Anschlussstifte von elektronischen Komponenten (2) befinden.

10. Verfahren zur Herstellung nach Anspruch 9, **dadurch gekennzeichnet, dass** es die Schritte umfasst, die im Wesentlichen darin bestehen, wenigstens eine elektronische überlagerte Komponente (7) mittels Löten auf einer Tochterkarte (8) zu befestigen, wenigstens eine elektronische Zwischenkomponente (6) auf der Hauptplatine (5) auf der Komponentenseite (4) zu positionieren, die Tochterkarte (8) senkrecht zu der Hauptplatine (5) zu platzieren, so dass sich die wenigstens eine überlagerte elektronische Komponente (7) in Kontakt oder in unmittelbarer Nachbarschaft zu der wenigstens einen elektronischen Zwischenkomponente (6) befindet, Anlöten der wenigstens einen Zwischenkomponente (6) an die Hauptplatine (5) und Anlöten der Tochterkarte an die Hauptplatine (5).

## Claims

1. Electronic device (1) comprising electronic components (2) and a first printed circuit board, called the motherboard (5), itself having a first side, called the component side (4), on which some of the electronic components (2) are located, some of the electronic components (2) being superposed on the component side (4) of the motherboard (5) so that at least one electronic component (2), called the intermediate component (6), is located directly between, on the one hand, the motherboard (5), and, on the other hand, another electronic component (2), called the superposed component (7);
**characterized in that**
the motherboard (5), on the opposite side to the first side, has a back side (3), on which solder joints to electronic component (2) connection pins are located.

2. Electronic device (1) according to Claim 1, **characterized in that**
the at least one intermediate electronic component (6) is soldered to the motherboard (5).

3. Electronic device (1) according to either one of Claims 1 and 2, **characterized in that**
the at least one intermediate electronic component (6) has an encapsulation made of plastic or another thermally insulating material.

4. Electronic device (1) according to any one of Claims 1 to 3, **characterized in that**
it comprises a second printed circuit board, placed perpendicularly to the motherboard (5) and to which the at least one superposed electronic component (7) is soldered.

5. Electronic device (1) according to Claim 4, **characterized in that**
the second printed circuit board is fastened to the motherboard (5) by soldering so as to form a daughterboard (8) that is mechanically and electrically connected to said motherboard (5).

6. Electronic device (1) according to any one of Claims 1 to 5, **characterized in that**
the at least one superposed electronic component (7) takes the form of a relay.

7. Electronic device (1) according to any one of the preceding claims, **characterized in that**:
it comprises a motherboard (5) bearing intermediate electronic components (6) soldered thereto and placed on the component side (4); and
it furthermore comprises a daughterboard (8), perpendicular to the motherboard (5) and soldered thereto in order to mechanically and electrically connect them,
said daughterboard (8) comprising a superposed electronic component (7), said superposed electronic component (7) being soldered to the daughterboard (8), positioned against the intermediate electronic components (6) and offset from the motherboard (5).

8. A home-automation control module having a power portion comprising electrical lines the state of which depends on at least one relay, and a control portion, allowing said relays to be controlled, **characterized in that**
it comprises an electronic device (1) according to any one of Claims 1 to 7, the superposed components (7) of which are preferably the relays for controlling the power lines.

9. Process for fabricating an electronic device (1) according to any one of Claims 1 to 7, comprising steps consisting in positioning and fastening, by soldering, to at least one printed circuit board, called the motherboard (5), at least one electronic component (2),
and in which
electronic components (2) are positioned superposed on the component side (4) of the motherboard (5) so that at least one electronic component (2), called the intermediate component (6), is located directly between, on the one hand, the motherboard (5), and, on the other hand, another electronic component (2), called the superposed component (7), the at least one intermediate component (6) preferably being brought to within the immediate vicinity of or even into contact with, on the one hand, the superposed component (7), and, on the other hand, the motherboard (5);
**characterized in that**
the motherboard (5), on the side opposite the first side, has a back side (3), on which solder joints to electronic component (2) connection pins are located.

10. Manufacturing process according to Claim 9, **characterized in that** it comprises steps consisting essentially in:
fastening, by soldering, to a daughterboard (8), at least one superposed electronic component (7);
positioning at least one intermediate electronic component (6) on the motherboard (5), on the component side (4);
placing the daughterboard (8) perpendicularly to the motherboard (5) so that the at least one superposed electronic component (7) is located making contact with or in the immediate vicinity of at least one intermediate electronic component (6); and
soldering the at least one intermediate component (6) to the motherboard (5), and soldering the daughterboard (8) to the motherboard (5).
